## Europäisches Patentamt
## European Patent Office
## Office européen des brevets

(11) Numéro de publication: **0 031 751**
**B1**

(12) **FASCICULE DE BREVET EUROPEEN**

(45) Date de publication du fascicule du brevet:
**04.05.83**

(51) Int. Cl.³: **H 03 K 13/08**, H 03 K 13/05

(21) Numéro de dépôt: **80401781.2**

(22) Date de dépôt: **12.12.80**

(54) Générateur de tension codée à transfert de charges, codeur et décodeur analogique-numérique comportant un tel générateur.

(30) Priorité: **27.12.79 FR 7931801**

(43) Date de publication de la demande:
**08.07.81 Bulletin 81/27**

(45) Mention de la délivrance du brevet:
**04.05.83 Bulletin 83/18**

(84) Etats contractants désignés:
**DE GB NL**

(56) Documents cités:
**FR-A-2 336 834**

(73) Titulaire: **THOMSON-CSF, 173, Boulevard Haussmann, F-75379 Paris Cedex 08 (FR)**

(72) Inventeur: **Benoit-Gonin, Roger, THOMSON-CSF SCPI 173, Bld Haussmann, F-75360 Cedex 08 (FR)**
Inventeur: **Berger, Jean-Luc, THOMSON-CSF SCPI 173, Bld Haussmann, F-75360 Cedex 08 (FR)**
Inventeur: **Coutures, Jean-Louis, THOMSON-CSF SCPI 173, Bld Haussmann, F-75360 Cedex 08 (FR)**

(74) Mandataire: **Benichou, Robert et al, THOMSON-CSF SCPI 173 bld Haussmann, F-75379 Paris Cedex 08 (FR)**

BUNDESDRUCKEREI BERLIN

Générateur de tension codée à transfert de charges, codeur et décodeur
analogique-numérique comportant un tel générateur

La présente invention concerne un générateur de tension codée à transfert de charges. Elle concerne également les codeurs et décodeurs analogiquesdigitaux comportant un tel générateur.

Il est bien connu dans l'art antérieur de déterminer par approximations successives les coefficients $a_0, a_1 \ldots a_i \ldots a_n$, égaux à 0 ou à 1, qui permettent d'écrire une tension $V_x$ inconnue sous la forme:

$$V_x = a_0 \cdot V_R + a_1 \cdot V_R/2 + a_2 \cdot V_R/2^2 + \ldots + a_i \cdot V_R/2^i + \ldots + a_n \cdot V_R/2^n,$$

où $V_R$ est une tension de référence.

Pour cela,

— $V_x$ est tout d'abord comparée à $V_R$ · Si $V_x$ est inférieure à $V_R$, alors $a_0$ égale 0, sinon $a_0$ égale 1;
— $V_x$ est ensuite comparée à $V_{R1} = a_0 V_R + V_R/2$ · Si $V_x$ est inférieure à $V_{R1}$, alors $a_1$ égale 0, sinon $a_1$ égale 1;
— puis $V_x$ est comparée à $V_{R2} = a_0 V_R + a_1 \cdot V_R/2 + V_R/4$ · Si $V_x$ est inférieure à $V_{R2}$, alors $a_2$ égale 0, sinon $a_2$ égale 1;

et ainsi de suite jusqu'à ce que tous les coefficients $a_0 \ldots a_n$ soient déterminés.

On constate donc qu'il est nécessaire pour déterminer par approximations successives les coefficients de disposer des tensions

$$V_R \text{ et } V_{Ri} = a_0 V_R + a_1 \cdot V_R/2 + a_2 \cdot V_R/2^2 + \ldots + a_{i-1} \cdot V_R/2^{i-1} + V_R/2^i$$

avec $i = 1 \ldots n$.

Les tensions $V_R$ et $V_{Ri}$ peuvent être générées par des réseaux de résistance ou de capacités dont les valeurs varient selon les puissances de 2. C'est le cas par exemple dans un article aux noms de McCreary et Gray, qui a été publié dans la revue IEEE Journal of Solid-State Circuits, volume SC 10, N° 6, décembre 1975, pages 371 à 385.

Ces réseaux de résistance ou de capacités présentent souvent l'inconvénient d'être encombrants et peu précis. De plus, avec certains de ces réseaux, il se révèle parfois impossible au cours de l'approximation d'engendrer directement une valeur de $V_{Ri}$ à partir de $V_{R(i-1)}$ et il faut recommencer une nouvelle séquence d'élaboration des tensions pour obtenir la bonne valeur de $V_{Ri}$. Ainsi pour générer les n valeurs de $V_{Ri}$ nécessaires à la détermination de n coefficients, il peut être nécessaire d'opérer $n \cdot (n+1)$ redistributions de tensions.

On connaît, par ailleurs, par les documents FR-A-2 343 369 et FR-A-2 336 834 des dispositifs qui utilisent la redistribution de charges; n redistributions de charges seulement sont nécessaires pour déterminer les n coefficients.

Par exemple le dispositif selon FR-A-2 343 369 comporte un générateur de quantités de charges $Q_R/2, Q_R/2^2 \ldots Q_R/2^n$. Deux régions de stockage des charges sont prévues:

— l'une où est stockée la quantité de charges $Q_x$ qui correspond à la tension inconnue $V_x$;
— l'autre qui reçoit $Q_R/2$.

Une comparaison est effectuée entre $Q_x$ et $Q_R/2$:

— si $Q_x > Q_R/2$, alors $a_0 = 1$ et $Q_R/2^2$ est aiguillée vers la région qui contient $Q_R/2$;
— si $Q_x < Q_R/2$, alors $a_0 = 0$ et $Q_R/2^2$ est aiguillée vers la région qui contient $Q_x$; et ainsi de suite jusqu'à l'obtention de $a_n$, chaque quantité de charges $Q_R/2^i$ est aiguillée vers l'une ou l'autre région en fonction de la valeur de $a_{i-1}$.

Le générateur de tension codée selon la présente invention utilise également la redistribution des charges mais diffère totalement par sa structure du dispositif connu précédemment décrit.

Le générateur selon l'invention possède tous les avantages du dispositif selon FR-A-2 343 369 au point de vue de l'encombrement réduit et de la rapidité notamment. De plus, il présente une précision accrue par rapport au dispositif selon FR-A-2 343 369.

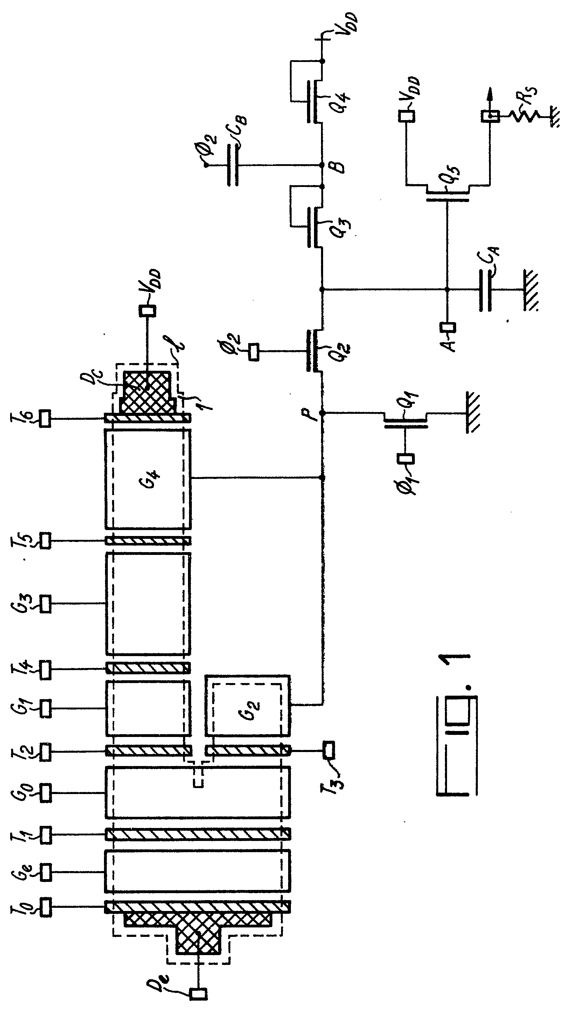

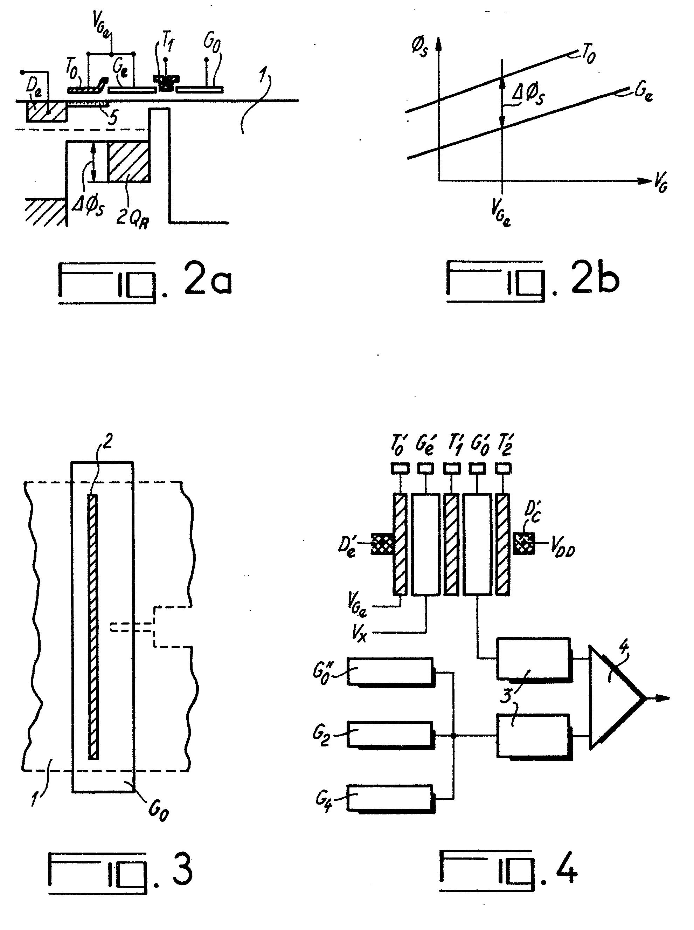

Dans ce dernier dispositif, les quantités de charges $Q_R/2, Q_R/2^2 \ldots Q_R/2^n$ sont obtenues voir les figures 3 à 5 en utilisant deux électrodes de stockage séparées par une électrode de transfert. Une quantité de charges $Q_R$ est stockée sous l'une des électrodes de stockage. La redistribution des charges sous les deux électrodes de stockage, puis leur séparation par l'électrode de transfert permet d'obtenir $Q_R/2$ sous chaque électrode de stockage. Les charges sous l'une des électrodes de stockage sont évacuées et on procède ensuite à une redistribution puis à une séparation qui permet d'obtenir $Q_R/4$, et ainsi de suite.

La répartition des charges lors de la division par 2 se fait de façon plus aléatoire que dans notre invention et la précision est donc moins bonne.

Le générateur de tension codée selon l'invention permet d'élaborer:

— soit les tensions

$$V_R, V_{Ri} = a_0 V_R + a_1 \cdot V_R/2 + a_2 \cdot V_R/2^2 + \ldots + a_{i-1} \cdot V_R/2^{i-1} + V_R/2^i$$

avec $i = 1 \ldots n$, dans le cas où on dispose d'une tension inconnue $V_x$ et où on veut déterminer par approximations successives en comparant $V_R$ et $V_{Ri}$ avec $V_x$ les coefficients $a_0 \ldots a_n$, égaux à 0 ou à 1 et tels que

$$V_x = a_0 V_R + a_1 V_R/2 + \ldots + a_i \cdot V_R/2^i + \ldots + a_n \cdot V_R/2^n;$$

— soit la tension

$$V_x = a_0 V_R + a_1 \cdot V_R/2 + \ldots + a_i \cdot V_R/2^i \ldots + a_n \cdot V_R/2^n,$$

dans le cas où les coefficients $a_0 \ldots a_n$ sont connus et où on ne dispose pas de $V_x$.

Le générateur selon l'invention est constitué par un dispositif à transfert de charges comportant en alternance des grilles de stockage et des grilles de transfert, avec:

— à une extrêmité de la zone active où s'effectuent le transfert et le stockage des charges, une diode $D_e$ qui assure, au début du traitement de chaque échantillon $V_x$ ou de chaque série $a_0 \ldots a_n$, l'injection d'une quantité de charges de référence $2Q_R$ et qui assure aussi l'évacuation des charges en surplus au cours du traitement;
— une diffusion d'isolement qui partage en deux parties égales les charges en provenance d'une grille de stockage $G_0$ située du côté de la diode $D_e$ et qui divise la zone active après $G_0$ en deux canaux parallèles;
— sur un canal, une grille de stockage $G_2$ sous laquelle se trouvent stockées par des allers-retours successifs entre $G_0$, $G_2$ les quantités de charges $Q_R$, $Q_R/2$, $\ldots Q_R/2^i \ldots$;
— sur l'autre canal, trois grilles de stockage $G_1$, $G_3$ et $G_4$, la quantité de charges $Q_R/2^i$ stockée sous $G_1$ en provenance de $G_0$ étant transférée sous $G_0$ puis évacuée sous $D_e$, lorsque $a_i$ est nul, pour $i = 0 \ldots n$, et étant transférée sous $G_3$, lorsque $a_i$ égale 1;
— lorsque les coefficients $a_0 \ldots a_n$ sont inconnus, un dispositif de lecture des charges relié à $G_2$ et $G_4$ qui assure l'élaboration de $V_R$ lors du transfert de $Q_R$ sous $G_2$, ce qui permet la détermination de $a_0$ par comparaison de $V_R$ avec $V_x$, puis l'élaboration de $V_{R1} = a_0 V_R + V_R/2$, lors du transfert de $Q_R/2$ sous $G_2$ et lors de l'éventuel transfert, si $a_0 = 1$, de $Q_R$ en provenance de $G_3$ vers $G_4$, ce qui permet la déterminaison de $a_1$, par comparaison de $V_{R1}$ avec $V_x$, et ainsi de suite jusqu'à l'élaboration de $V_{Rn}$ et la détermination de $a_n$, ou,
  lorsque les coefficients $a_0 \ldots a_n$ sont connus, un dispositif de lecture des charges relié à $G_4$ qui assure l'élaboration de $V_x$ par transfert des charges de $G_3$ vers $G_4$, lorsque les n coefficients de $V_x$ ont été traités.

Par ailleurs, selon un mode préféré de réalisation du générateur selon l'invention, dans le cas où on dispose de la tension $V_x$ et où les coefficients $a_0 \ldots a_n$ sont inconnus, on peut pour éviter toute source de tension référence extérieure, convertir la tension à coder $V_x$ en une quantité de charges $Q_x$ grâce à un dispositif d'injection des charges identique à celui qui est utilisé pour générer $2Q_R$. On effectue ensuite une lecture de $Q_x$, soit $V_{Lx}$, grâce à un dispositif identique à celui qui est utilisé pour lire les charges sous $G_2$ et $G_4$. L'avantage de la conversion, puis de la lecture de $Q_x$ est de comparer des signaux $V_{Lx}$ et $V_{Ri}$ ayant la même composante continue et la même échelle d'amplitude.

Le générateur selon l'invention présente l'avantage de pouvoir être utilisé dans des codeurs ou décodeurs analogiques-digitaux comme cela est décrit dans l'article aux noms de Gray et Hodges, paru sous le titre »All MOS analogic-digital conversion techniques« paru dans la revue IEEE Transactions on circuits and systems, volume CAS-25, numéro 7, juillet 78, pages 482 à 489.

D'autres objets, caractéristiques et résultats de l'invention ressortiront de la description suivante, donnée à titre d'exemple non limitatif et illustrée par les figures annexées qui représentent:

— la figure 1, une vue de dessus du dispositif à transfert de charges constituant le générateur selon l'invention et le schéma électrique du dispositif constitué de transistors MOS, capacités et résistances qui lui est associé;
— la figure 2a, une vue en coupe du dispositif d'injection des charges du générateur selon l'invention et les potentiels de surface sous ce dispositif à un instant donné, et la figure 2b, l'évolution du potentiel de surface $\Phi_S$ en fonction de la tension appliquée $V_G$ à deux grilles $T_0$ et $G_E$ du dispositif d'injection;
— la figure 3, un schéma montrant les zones diffusées dans le substrat sous l'une des grilles, $G_0$, du

dispositif à transfert de charges constituant le générateur;
— la figure 4, un schéma montrant l'organisation du générateur selon l'invention lorsque la tension à coder $V_x$ est convertie en charges qui sont lues avant que soit effectuée la comparaison avec les tensions $V_{Ri}$.

Sur les différentes figures, les mêmes repères désignent les mêmes éléments, mais, pour des raisons de clarté, les cotes et proportions des différents éléments ne sont pas respectées.

La figure 1 représente une vue de dessus du dispositif à transfert de charges constituant le générateur selon l'invention et le schéma électrique du dispositif constitué de transistors MOS, capacités et résistances qui lui est associé.

Ce dispositif à transfert de charges est préférentiellement du type C.C.D. (Charge Coupled Devices).

Le transfert des charges peut se faire en surface ou en volume.

La zone active du substrat semi-conducteur où s'effectue le transfert et le stockage des charges se situe à l'intérieur de la ligne I en trait discontinu. A l'extérieur de la zone délimitée par cette ligne, un surdopage du substrat élève le seuil d'inversion et s'oppose ainsi à tout stockage des charges.

A une extrêmité de la zone active, l'extrêmité gauche sur la figure, on trouve une diode $D_e$ qui permet d'introduire une charge de référence $2Q_R$ sous une grille de stockage $G_e$ par l'intermédiaire d'une grille de transfert $T_0$. La diode $D_e$ et les grilles $T_0$ et $G_e$ constituent le dispositif d'injection de la charge de référence $2Q_R$ dans le générateur.

La diode $D_e$ est également utilisée pour l'évacuation des charges en surplus au cours du fonctionnement du générateur.

La grille $G_e$ est suivie d'une grille de transfert $T_1$ et d'une grille de stockage $G_0$.

Sous $G_0$, une diffusion d'isolement s'avance, à la moitié de la largeur de la zone active de transfert des charges pour effectuer un pré-partage de la charge stockée sous $G_0$ en deux quantités de charges égales. Cette diffusion d'isolement divise la zone active après $G_0$ en deux canaux parallèles, généralement de même largeur. Ainsi sous les grilles de stockage $G_1$ et $G_2$, situées sur chaque canal après $G_0$ et séparées de $G_0$ par les grilles de transfert $T_2$ et $T_3$, seront transférées deux quantités de charges égales à la moitié de la charge stockée sous $G_0$. Ce partage d'une quantité de charges par une zone diffusée est connu de l'art antérieur.

L'un des canaux se termine donc par la grille de stockage $G_2$, tandis que l'autre canal comporte après la grille de stockage $G_1$ deux grilles de stockage $G_3$ et $G_4$ et trois grilles de transfert, $T_4$ entre $G_1$ et $G_3$, $T_5$ entre $G_3$ et $G_4$ et $T_6$ entre $G_4$ et une diode collectrice $D_c$. La diode collectrice $D_c$ qui termine le canal est reliée à une tension continue $V_{DD}$ et permet l'évacuation des charges en fin de traitement d'un échantillon $V_x$ ou d'une série $a_0 \ldots a_n$.

Selon que l'on dispose de $V_x$ ou des coefficients $a_0 \ldots a_n$, les grilles $G_2$ et $G_4$ ou la grille $G_4$ seulement sont connectées en un point P à un dispositif de lecture des charges qui opère une lecture non destructive des charges stockées sous $G_2$ et $G_4$ ou sous $G_4$ seulement.

Ce dispositif de lecture peut être un dispositif de lecture des charges en courant connu dans l'art antérieur, tel par exemple celui qui est décrit par la demande de brevet français N° 77.13857 publiée sous le N° 2 389 899 au nom de THOMSON-CSF.

Le potentiel du point P est maintenu constant lors de l'arrivée des charges grâce à un transistor MOS $Q_2$, relié entre le point P et un point A. Le transistor $Q_2$, commandé par un signal d'horloge périodique $\Phi_2$, se trouve alors polarisé en saturation. Le courant qui traverse $Q_2$ lors de l'afflux des charges est intégré dans une capacité $C_A$ reliée entre le point A et la masse.

La tension au point A est lue par un transistor MOS ou TMOS $Q_5$ monté en suiveur, dont la grille est reliée au point A, dont l'une des électrodes est reliée à une tension $V_{DD}$ et dont l'autre électrode fournit la tension de lecture aux bornes d'une résistance $R_S$. Le TMOS $Q_5$ peut être remplacé pour lire la tension au point A par un amplificateur opérationnel de gain I.

Entre le point A et un point B est également connecté un TMOS $Q_3$ dont la grille est reliée à B. Une capacité $C_B$ est reliée entre le point B et le signal d'horloge $\Phi_2$. Enfin un TMOS $Q_4$ est relié entre le point B et la tension $V_{DD}$, la grille de $Q_4$ est aussi reliée à $V_{DD}$.

Enfin, selon que l'on dispose de $V_x$ ou des coefficients $a_0 \ldots a_n$, un TMOS $Q_1$ est connecté entre les grilles $G_2$ et $G_4$ et la masse ou entre la grille $G_2$ seulement et la masse. Le TMOS $Q_1$ est commandé par un signal d'horloge périodique $\Phi_1$ et provoque lorsqu'il conduit la remise à zéro des grilles auxquelles il est connecté.

Nous allons maintenant étudier le fonctionnement du générateur représenté sur la figure 1 où le point P du dispositif de lecture et le TMOS $Q_1$ sont connectés aux grilles $G_2$ et $G_4$. Il s'agit donc du cas où on dispose d'échantillons $V_x$ et où on veut déterminer les coefficients $a_0 \ldots a_n$ en élaborant les tensions $V_R$ et $V_{Ri}$.

On peut distinguer cinq séquences dans ce fonctionnement:

— séquence $t_0$: une charge $2Q_R$ est introduite sous la grille $G_e$ de façon connue par la méthode dite »fill and spill«. Pour cela, la diode $D_e$ est successivement portée à un niveau bas qui permet le passage des charges de $D_e$ sous $T_0$ et $G_e$, puis à un niveau haut qui permet de stocker sous $G_e$ une quantité de charge donnée $2Q_R$.

4

**0 031 751**

Les grilles $T_0$ et $G_e$ reçoivent la même tension $V_{GE}$, comme cela est représenté sur la figure 2a qui représente une vue en coupe du dispositif d'injection des charges et les potentiels de surface lorsque la charge $2Q_R$ est stockée sous $G_e$.

La quantité de charges de référence $2Q_R$ est stable au premier ordre, c'est-à-dire indépendante des variations de la tension $V_{GE}$ appliquée à $T_0$ et $G_E$, si les courbes de potentiel de surface en fonction de la tension de ce couple de grilles sont parallèles. Pour cela, on ajuste les tensions seuils sous $T_0$ et $G_e$ par implantation 5 sous $T_0$ de façon que la hauteur de barrière $\Delta Q_S$ soit indépendante au premier ordre de $V_{GE}$. La figure 2b représente les courbes obtenues pour $T_0$ et $G_e$.

Les autres électrodes de transfert du générateur $T_1 \ldots T_6$ peuvent être réalisés sur une surépaisseur d'oxyde comme cela est représenté pour $T_1$ sur la figure 2a. Elles peuvent aussi comme $T_0$ être réalisées par implantation où être réalisées toute autre façon connue.

— séquence $t_1$: la charge $2Q_R$ est transférée sous $G_0$. Le signal d'horloge $\Phi_2$ est au niveau haut $V_\Phi$ de sorte que le point B initialement préchargé par $Q_4$ à $V_{DD} - V_T$ passe à $V_B = V_{DD} - V_T + V_\Phi$, et le point A à $V_B - V_T$, où $V_T$ est la tension de seuil commune aux TMOS $Q_2$, $Q_3$ et $Q_4$. Le point P et les grilles $G_2$ et $G_4$ sont ainsi pré-chargés à $V_\Phi - V_T$ et le TMOS $Q_2$ se trouve polarisé en saturation car $C_{A0} = V_B - V_T > V_\Phi - V_T$,
— séquence $t_2$: la charge $2Q_R$ présente sous $G_0$ est transférée vers $G_1$ et $G_2$ par la mise à zéro de $G_0$ car les grilles $T_2$ et $T_3$ sont à des potentiels fixes intermédiaires. Les charges sont donc transférées par dessus les barrières de potentiel induites sous $T_2$ et $T_3$ ce qui supprime les parasites que pourrait produire la mise à zéro de $T_2$ et $T_3$ sur les grilles de lecture $G_1$ et $G_2$.

On dispose donc de la charge $Q_R$ sous $G_1$ et de la charge $Q_R$ sous $G_2$ à cause du partage des charges réalisé par la diffusion d'isolement.

Dans ce même temps, $T_4$ et $G_3$ sont mises à zéro et $T_5$ à un potentiel fixe intermédiaire ce qui correspond au transfert d'une charge éventuelle de $G_3$ vers $G_4$.

Lors de la première séquence $t_2$ il n'y a pas de charges à transférer de $G_3$ vers $G_4$ et c'est l'arrivée de $Q_R$ sous $G_2$ qui provoque seule le passage d'un courant à travers $Q_2$ qui maintient le potentiel au point P à $V_\Phi - V_T$ alors que le potentiel en A passe de $V_{A0}$ à $V_A = V_{A0} - Q_R/C_A = V_{A0} - V_R$.

On dispose donc par l'intermédiaire du TMOS $Q_5$ monté en suiveur d'une tension $V_S$ proportionnelle à $V_R = Q_R/C_A$. La tension $V_R$ est ensuite comparée, de façon connue, à l'échantillon $V_x$ à coder et on en déduit la valeur de $a_0$:

— $a_0 = 0$ si $V_x < V_R$
— $a_0 = 1$ si $V_x > V_R$

— séquence $t_3$: selon la valeur de $a_0$, les transferts de charges diffèrent:

— si $a_0 = 0$, la charge $Q_R$ est transférée de $G_1$ sous $G_0$ puis sous $G_e$ et elle est enfin évacuée par la diode $D_e$;
— si $a_0 = 1$, la charge $Q_R$ est transférée de $G_1$ sous $G_3$. La charge $a_0 Q_R$ se trouve donc stockée sous $G_3$;

— séquence $t_4$: le passage de $\Phi_1$ au niveau haut, alors que $\Phi_2$ passe au niveau bas, rend conducteur le TMOS $Q_1$ et provoque la remise à zéro de $G_2$, et donc le transfert de $Q_R$ de $G_2$ vers $G_0$, et la remise à zéro de $G_4$, et donc le transfert d'une charge éventuelle de $G_4$ vers $G_3$.

Les différentes séquentes sont ensuite reprises à partir de la séquence $t_1$, la séquence $t_0$ n'a pas lieu puisqu'on dispose de la charge $Q_R$ sous $G_0$.

On a ainsi successivement:

— séquence $t_1$: pré-charge des points A et P;
— séquence $t_2$:

— transfert de $Q_R/2$ sous $G_2$ et de $Q_R/2$ sous $G_1$;
— transfert de $a_0 Q_R$ de $G_3$ vers $G_4$;
— lecture de $a_0 Q_R + Q_R/2$;
— comparaison de $V_{R1} = (a_0 \cdot Q_R + Q_R/2) \cdot C_A$ avec $V_x$ et détermination de $a_1$.

— séquence $t_3$:

— si $a_1 = 0$, évacuation de $Q_R/2$ de $G_1$ vers $G_0$, $G_e$ et $D_e$;
— si $a_1 = 1$, transfert de $Q_R/2$ de $G_1$ sous $G_3$.

5

— séquence $t_4$:

- transfert de $Q_R/2$ de $G_2$ vers $G_0$;
- transfert de $a_0 Q_R$ de $G_4$ vers $G_3$. On trouve alors sous $G_3$ la charge $a_0 Q_R + a_1 Q_R/2$.

Les différentes séquences sont ensuite reprises à partir de $t_1$ jusqu'à la détermination de $a_n$. Pour la détermination de chaque coefficient $a_i$, il faut donc une séquence de pré-charge $t_1$ et trois séquences $t_2$, $t_3$, $t_4$ de transfert successives donc certaines comportent plusieurs transferts simultanés.

Pour la détermination de n coefficients, il faut donc 4n séquences successives après quoi le générateur est initialisé pour le codage de l'échantillon $V_x$ suivant, il y a alors évacuation de $Q_R/2^n$ de $G_2$ vers $G_0$, $G_e$ et $D_e$ et des charges stockées sous $G_4$ vers $D_c$.

Les grilles $G_1$ et $G_2$ ont de préférence une surface égale à la moitié de celle de $G_0$. Les grilles $G_3$ et $G_4$ ont de préférence une surface égale à celle de $G_0$. On peut remarquer que lorsque tous les coefficients sont égaux à 1, la quantité de charges à stocker sous $G_3$ et $G_4$ est proche de $2Q_R$ puisqu'elle égale $Q_{Rn} = 2Q_R(1 - 1/2^n)$.

Pendant la séquence $t_4$, la charge $Q_R/2^i$ est transférée de $G_2$ vers $G_0$. Avant de pouvoir transférer à nouveau cette charge sous les grilles $G_1$ et $G_2$ pour la diviser par 2, il est essentiel qu'elle ait eu le temps de se répartir de façon uniforme sous $G_0$. Or pour avoir une précision suffisante sur le partage de la charge, on utilise une grille $G_0$ dont la largeur perpendiculairement au sens de transfert des charges est relativement importante de l'ordre de 300 μm par exemple. Le temps de répartition homogène d'une charge sous une électrode d'une telle largeur est relativement élevé. Pour diminuer ce temps de répartition d'une façon notable, on dispose sur toute la largeur de $G_0$ une zone diffusée de type opposé à celui du substrat semi-conducteur 1.

Sur la figure 3, on a repéré par 2 la zone diffusée sous l'électrode $G_0$ qui établit une conduction élevée d'un bout à l'autre de l'électrode ce qui facilite le passage des charges et leur répartition homogène sur toute la surface de $G_0$.

Pour éviter toute source de tension référence extérieure, on peut convertir la tension à coder $V_x$ en une quantité de charges $Q_x$ grâce à un dispositif d'injection identique à celui qui est utilisé pour générer $2Q_R$.

Ce dispositif est représenté sur la figure 4 et comporte une diode $D_e'$ suivie d'une grille de transfert $T_0'$ reliée à $V_{Ge}$ et d'une grille de stockage $G_e'$ reliée à $V_x$.

On effectue ensuite une lecture de $Q_x$ sur une grille de stockage $G_0'$ adjacente au dispositif d'injection à l'aide d'un dispositif de lecture identique à celui qui est utilisé pour lire les charges sous $G_2$ et $G_4$. On obtient ainsi une tension $V_A' = V_{A0} - Q_x/C_A$ à comparer avec la tension $V_{Ai} = V_{A0} - Q_{Ri}/C_A$.

L'avantage de la conversion, puis de la lecture de $Q_x$ est de disposer de signaux $V_A'$ et $V_{Ai}$ tout à fait comparables en ce qui concerne leur composante continue et leur échelle d'amplitude.

La génération de $Q_x$ doit se faire pour la détermination de chaque coefficient $a_i$. L'injection sous $G_e'$ a lieu pendant la séquence $t_1$, le transfert et la lecture sous $G_0'$ pendant la séquence $t_2$ et l'évacuation sous une diode $D_c'$ reliée à $V_{DD}$ et séparée de $G_0'$ par une grille de transfert $T_2'$ pendant la séquence $t_3$. On doit donc disposer d'une tension $V_x$ échantillonnée et maintenue.

On choisit de préférence la surface de $G_e'$ identique à celle de $G_e$. La charge maximale $2Q_R$ qui peut être traitée par le générateur est alors introduite sous $G_e'$ lorsque $V_x$ égale $V_{GE}$.

Pour obtenir une bonne précision sur la charge minimale qui peut être injectée sous $G_e'$ et lue par la suite, on superpose à la tension $V_x$ une tension constante $V_0$.

L'excursion de tension sur $G_e'$ va alors de $V_0$ à $V_0 + V_{GE}$. Les quantités de charges sous $G_e'$ varient donc entre $Q_0$ et $Q_0 + 2Q_R$.

Pour pouvoir toujours effectuer une comparaison entre $V_A'$ et $V_{Ai}$, on ajoute aux charges arrivant sous $G_2$ et $G_4$ une quantité de charges $Q_0$. Pour cela une grille de stockage supplémentaire $G_0''$ est connectée au point P, comme cela est représenté schématiquement sur la figure 4. Une quantité de charges $Q_0$ est alors injectée puis transférée sous $G_0''$ grâce à un dispositif identique à celui qui génère et transfère $Q_0 + Q_x$. Les quantités de charges $Q_0 + Q_x$ et $Q_0 + Q_{Ri}$ sont lues par des dispositifs de lecture 3 et un comparateur 4 effectue la comparaison entre les signaux $V_A' = V_{A0} - (Q_0 + Q_x)/C_A$ et $V_{Ai} = V_{A0} - (Q_0 + Q_{Ri})/C_A$.

Les dispositifs d'injection de $2Q_R$, $Q_x + Q_0$ et $Q_0$ doivent être suffisamment rapprochés sur le substrat semi-conducteur pour éviter des variations des paramètres technologiques d'un dispositif à l'autre en ce qui concerne la tension de seuil, l'épaisseur d'oxyde ... Ces précautions étant prises, il est possible d'éviter l'emploi d'une source de tension référence externe.

Enfin, lorsque la tension à coder $V_x$ est négative, la comparaison entre $V_x$ et les tensions $V_R$, $V_{Ri}$ s'effectue après que la tension $V_x$ ou les tensions $V_R$, $V_{Ri}$ aient été inversées de signe par un étage différentiel.

Nous allons maintenant étudier le fonctionnement du générateur selon l'invention lorsque le point P du dispositif de lecture n'est relié qu'à $G_4$ et lorsque le TMOS $Q_1$ n'est relié qu'à $G_2$. Il s'agit donc du cas où on connait les coefficients $a_0 \ldots a_n$ et où on veut élaborer $V_x$. Une seule lecture des charges est alors nécessaire elle se fait par transfert de $G_3$ vers $G_4$ alors qu'on a stocké sous $G_3$ la quantité de charges $a_0 Q_R + a_1 Q_R/2 + \ldots + a_n Q_R/2^n$.

Nous allons examiner ce qui diffère au cours des séquences $t_1$ à $t_4$ précédemment décrites, la séquence $t_0$ restant inchangée.

— séquence $t_1$: c'est la séquence de pré-charge des points A et P en vue de la lecture des charges. Dans ce cas, une seule lecture est effectuée lorsque tous les coefficients $a_0 \ldots a_n$ ont été traités. A la différence de ce qui se passait précédemment, la séquence $t_1$ n'a lieu qu'une seule fois pour le traitement d'une série $a_0 \ldots a_n$, comme c'est le cas pour la séquence $t_0$. La période du signal d'horloge $\Phi_2$ doit donc être modifiée;

— séquence $t_2$: il y a toujours transfert de $Q_R$ puis $Q_R/2$, $Q_R/2^2 \ldots$ sous $G_1$ et $G_2$, mais il n'y a plus à chaque fois transfert de $G_3$ vers $G_4$, lecture des charges sous $G_2$ et $G_4$ et comparaison de la tension de lecture $V_{Ri}$ avec $V_x$ pour déterminer $a_i$. Le transfert de $G_3$ vers $G_4$ et la lecture sous $G_4$ n'ont lieu qu'une seule fois lorsque toutes les valeurs des coefficients $a_i$ ont été traités;

— séquence $t_3$: elle n'est pas modifiée et il y a toujours selon la valeur de $a_i$ évacuation des charges de $G_3$ vers $D_e$ ou transfert de $G_3$ vers $G_4$. On trouve donc sous $G_3$ la charge $a_0Q_R + a_1Q_R/2 + \ldots + a_i \cdot Q_R/2^i$;

— séquence $t_4$: seule la grille $G_2$ est remise à zéro par le TMOS $Q_1$.

Il est bien entendu que la totalité du générateur selon l'invention peut être intégrée sur le même substrat semi-conducteur.

## Revendications

1. Générateur de tension codée à transfert de charges élaborant des tensions $V_R$,

$$V_{Ri} = a_0V_R + a_1 \cdot V_R/2 + a_2 \cdot V_R/2^2 + \ldots + a_{i-1} \cdot V_R/2^{i-1} + V_R/2^i,$$

où $V_R$ est une tension de référence et où $i = 1 \ldots n$, ces tensions permettant par comparaison avec une tension $V_x$ de déterminer par approximations successives les coefficients $a_0 \ldots a_n$, égaux à 0 ou à 1 et tels que

$$V_x = a_0V_R + a_1 \cdot V_R/2 + a_2 \cdot V_R/2^2 \ldots + a_iV_R/2^i + \ldots + a_n \cdot V_R/2^n,$$

ou élaborant dans le cas où les coefficients $a_0 \ldots a_n$ sont connus, la tension

$$V_x = a_0V_R + a_1 \cdot V_R/2 + a_2 \cdot V_R/2^2 + \ldots + a_i \cdot V_R/2^i + \ldots + a_n \cdot V_R/2^n,$$

caractérisé en ce qu'il est constitué par un dispositif à transfert de charges comportant en alternance des grilles de stockage et des grilles de transfert, avec:

— à une extrêmité de la zone active où s'effectuent le transfert et le stockage des charges, une diode $D_e$ qui assure, au début du traitement de chaque échantillon $V_x$ ou de chaque série $a_0 \ldots a_n$, l'injection d'une quantité de charges de référence $2Q_R$ et qui assure aussi l'évacuation des charges en surplus au cours du traitement:

— une diffusion d'isolement qui partage en deux parties égales les charges en provenance d'une grille de stockage $G_0$ située du côté de la diode $D_e$ et qui divise la zone active après $G_0$ en deux canaux parallèles;

— sur un canal, une grille de stockage $G_2$ sous laquelle se trouvent stockées par des allers-retours successifs entre $G_0$ et $G_2$ les quantités de charges, $Q_R$, $Q_R/2 \ldots Q_R/2^i \ldots$;

— sur l'autre canal, trois grilles de stockage $G_1$, $G_3$ et $G_4$, la quantité de charges $Q_R/2^i$ stockée sous $G_1$ en provenance de $G_0$ étant transférée sous $G_0$ puis évacuée sous $D_e$ lorsque $a_i$ est nul, pour $i = 0 \ldots n$, et étant transférée sous $G_3$, lorsque $a_i$ égale 1;

— lorsque les coefficients $a_0 \ldots a_n$ sont inconnus un dispositif de lecture des charges relié à $G_2$ et $G_4$ qui assure l'élaboration de $V_R$ lors du transfert de $Q_R$ sous $G_2$, ce qui permet la détermination de $a_0$ par comparaison de $V_R$ avec $V_x$, puis l'élaboration de $V_{R1} = a_0V_R + V_R/2$, lors du transfert de $Q_R/2$ sous $G_2$ et lors de l'éventuel transfert, si $a_0 = 1$, de $Q_R$ en provenance de $G_3$ vers $G_4$, ce qui permet la détermination de $a_1$ par comparaison de $V_{R1}$ avec $V_x$, et ainsi de suite jusqu'à l'élaboration de $V_{Rn}$ et la détermination de $a_n$, ou, lorsque les coefficients $a_0 \ldots a_n$ sont connus, un dispositif de lecture des charges relié à $G_4$ qui assure l'élaboration de $V_x$ par transfert des charges de $G_3$ vers $G_4$, lorsque les n coefficients de $V_x$ ont été traités.

2. Générateur selon la revendication 1, caractérisé en ce que les grilles $G_1$ et $G_2$ ont une surface égale à la moitié de celle des grilles $G_0$, $G_3$, et $G_4$.

3. Générateur selon l'une des revendications 1 ou 2, caractérisé en ce que les deux canaux parallèles ont la même largeur.

4. Générateur selon l'une des revendications 1 à 3, caractérisé en ce que la diode $D_e$ est suivie par un couple électrode de transfert $T_0$ — électrode de stockage $G_e$ qui reçoivent la même tension ($V_{GE}$), l'implantation sous l'électrode de transfert $T_0$ étant adaptée pour que les courbes de potentiel de surface en fonction de la tension de ce couple de grilles soient parallèles et la diode $D_e$ étant successivement portée à un niveau bas qui permet le passage des charges de $D_e$ sous $T_0$ et $G_e$ puis à un niveau haut qui permet de stocker la quantité de charges $2Q_R$ sous $G_e$.

5. Générateur selon l'une des revendications 1 à 4, caractérisé en ce qu'il comporte sur l'un des canaux à la suite de la grille de stockage $G_4$ une diode ($D_c$) qui permet en fin de traitement l'évacuation des charges stockées sous $G_4$.

6. Générateur selon l'une des revendications 1 à 5, caractérisé en ce que la grille de stockage $G_0$ ayant une largeur, perpendiculairement au sens de transfert des charges, suffisamment importante pour permettre le partage des charges stockées sous $G_0$ en deux parties égales avec une bonne précision, une zone diffusée de type opposé à celui du substrat (1) est disposée sur toute la largeur de $G_0$ pour diminuer le temps de répartition des charges sous $G_0$.

7. Générateur selon l'une des revendications 1 à 6, la tension $V_x$ étant disponible et les coefficients $a_0$ ... $a_n$ étant inconnus, caractérisé en ce qu'il comporte une diode d'injection $D_e'$ identique à $D_e$ suivie d'un couple électrode de transfert $T_0'$ — électrode de stockage $G_e'$ identique au couple $T_0 - G_e$, la diode $D_e'$ étant successivement portée à un niveau bas et à niveau haut. La grille $T_0'$ étant portée à $V_{GE}$ et la grille $G_e'$ recevant la tension $V_x$, les charges injectées sous $G_e'$ étant lue par un dispositif identique à celui qui est relié à $G_2$ et $G_4$ et le résultat de cette lecture étant comparé à la lecture réalisée sous $G_2$ et $G_4$ pour la détermination des coefficients $a_0$ ... $a_n$.

8. Générateur selon la revendication 7, caractérisé en ce que la tension $V_x$ appliquée à $G_e'$ varie entre $V_0$ et $V_0 + V_{Ge}$ et la quantité de charges injectée sous $G_e'$ entre $Q_0$ et $Q_0 + 2Q_R$, une quantité de charges égale à $Q_0$ étant ajoutée aux charges arrivant sous les grilles $G_2$ et $G_4$ grâce à une grille de stockage $G_0''$ connectée au point P et sous laquelle une quantité de charges $Q_0$ est injectée grâce à un dispositif d'injection identique à celui qui génère les quantités de charges $Q_0 + Q_x$ et $2Q_R$.

9. Générateur selon la revendication 7, caractérisé en ce que la tension $V_x$ étant négative, avant d'effectuer la comparaison entre $V_x$ et les tensions $V_R$, $V_{Ri}$, la tension $V_x$ ou les tensions $V_R$, $V_{Ri}$ sont inversées de signe par un étage différentiel.

10. Codeur analogique-digital, caractérisé en ce qu'il comporte un générateur selon l'une des revendications 1 à 9.

11. Décodeur analogique-digital, caractérisé en ce qu'il comporte un générateur selon l'une des revendications 1 à 6.

**Patentansprüche**

1. Mit Ladungsverschiebung arbeitender Generator zur Erzeugung einer codierten Spannung, welcher die Spannungen

$$V_R, V_{Ri} = a_0 V_R + a_1 \cdot V_R/2 + a_2 \cdot V_R/2^2 + \ldots + a_{i-1} \cdot V_R/2^{i-1} + V_R/2^i$$

erzeugt, worin $V_R$ eine Bezugsspannung und worin $i = 1 \ldots n$ ist, wobei diese Spannungen durch Vergleichen mit einer Spannung $V_x$ es ermöglichen, die Koeffizienten $a_0 \ldots a_n$, durch sukzessive Approximierungen zu bestimmen, welche gleich 0 oder gleich 1 und so bestimmt sind, daß

$$V_x = a_0 V_R + a_1 \cdot V_R/2 + a_2 \cdot V_R/2^2 \ldots + a_i V_R/2^i + \ldots + a_n \cdot V_R/2^n,$$

oder welcher für den Fall, daß die Koeffizienten $a_0 \ldots a_n$ bekannt sind, die Spannung

$$V_x = a_0 V_R + a_1 \cdot V_R/2 + a_2 \cdot V_R/2^2 + \ldots + a_i \cdot V_R/2^i + \ldots + a_n \cdot V_R/2^n$$

erzeugt, dadurch gekennzeichnet, daß er gebildet ist aus einer Ladungsverschiebevorrichtung, die miteinander abwechselnde Speicherelektroden und Verschiebeelektroden aufweist, mit:

— an einem Ende der Zone, wo die Überführung und die Speicherung der Ladungen stattfindet, einer Diode $D_e$, die am Anfang der Verarbeitung jeder Probe $V_x$ oder jeder Serie $a_0 \ldots a_n$ die Injektion einer Bezugsladungsgröße $2Q_R$ gewährleistet und ferner im Verlaufe der Verarbeitung die Beseitigung der überschüssigen Ladungen gewährleistet;

— einer isolierenden Diffusion, welche die von einer auf der Seite der Diode $D_e$ liegenden Speicherelektrode $G_0$ kommende Ladung in zwei gleiche Teile unterteilt und welche die auf $G_0$ folgende aktive Zone in zwei parallele Kanäle unterteilt;

— an einem Kanal eine Speicherelektrode $G_2$, unter welcher die Ladungsgrößen $Q_R$, $Q_R/2 \ldots Q_R/2^i$ durch aufeinanderfolgende Hin- und Herbewegungen zwischen $G_0$ und $G_2$ gespeichert sind;

— an dem anderen Kanal drei Speicherelektroden $G_1$, $G_3$, $G_4$, wobei die unter $G_1$ gespeicherte Ladungsgröße $Q_R/2^i$ von $G_0$ unter $G_0$ verschoben und dann unter $D_e$ abgeführt wird, wenn $a_i$ gleich 0 ist, für $i = 0 \ldots n$, und unter $G_3$ verschoben wird, wenn $a_i$ gleich 1 ist;

— wenn die Koeffizienten $a_0 \ldots a_n$ unbekannt sind, mit einer Ladungslesevorrichtung, die mit $G_2$ und $G_4$ verbunden ist und die Erzeugung von $V_R$ während der Verschiebung von $Q_R$ unter $G_2$ gewährleistet, was die Bestimmung von $a_0$ durch Vergleich von $V_R$ mit $V_x$ und anschließend die Erzeugung von $V_{R1} = a_0 V_R + V_R/2$ während der Verschiebung von $Q_R/2$ unter $G_2$ und während der eventuellen Verschiebung, wenn $a_0 = 1$, der Größe $Q_R$ von $G_3$ zu $G_4$ gestattet, was die Bestimmung von $a_1$ durch Vergleich von $V_{R1}$ mit $V_x$ gestattet, und so weiter bis zur Erzeugung von $V_{Rn}$ und zur Bestimmung von $a_n$, oder, wenn die Koeffizienten $a_0 \ldots a_n$ bekannt sind, mit einer Ladungslesevorrichtung, die mit $G_4$ verbunden ist und die Erzeugung von $V_x$ durch Verschiebung der Ladungen von $G_3$ zu $G_4$ gewährleistet, wenn die n Koeffizienten von $V_x$ verarbeitet worden sind.

2. Generator nach Anspruch 1, dadurch gekennzeichnet, daß die Elektroden $G_1$ und $G_2$ eine Oberfläche aufweisen, die gleich der Hälfte derjenigen der Elektroden $G_0$, $G_3$ und $G_4$ ist.

3. Generator nach Anspruch 1 oder 2, dadurch gekennzeichnet, daß die beiden parallelen Kanäle dieselbe Breite aufweisen.

4. Generator nach einem der Ansprüche 1 bis 3, dadurch gekennzeichnet, daß auf die Diode $D_e$ ein Elektrodenpaar aus einer Verschiebeelektrode $T_0$ und einer Speicherelektrode $G_e$ folgt, welche dieselbe Spannung ($V_{GE}$) empfangen, wobei die Implantation unter der Verschiebeelektrode $T_0$ so ausgelegt ist, daß die Oberflächenpotentialkurven in Abhängigkeit von der Spannung dieses Elektrodenpaares parallel sind, wobei die Diode $D_e$ nacheinander auf niedrigen Pegel gebracht wird, wodurch die Ladungen von $D_e$ unter $T_0$ und $G_e$ gelangen können, und auf hohen Pegel gebracht wird, wodurch die Ladungsgröße $2Q_R$ unter $G_e$ gespeichert werden kann.

5. Generator nach einem der Ansprüche 1 bis 4, dadurch gekennzeichnet, daß er an einem der Kanäle im Anschluß an die Speicherelektrode $G_4$ eine Diode ($D_c$) aufweist, die am Ende der Verarbeitung die Beseitigung der unter $G_4$ gespeicherten Ladungen ermöglicht.

6. Generator nach einem der Ansprüche 1 bis 5, dadurch gekennzeichnet, daß die Speicherelektrode $G_0$, deren senkrecht zur Ladungsverschieberichtung gemessene Breite ausreichend groß ist, damit die unter $G_0$ gespeicherten Ladungen mit guter Präzision in zwei gleiche Teile unterteilt werden können, eine diffundierte Zone des dem Substrat (1) entgegengesetzten Typs aufweist, die auf der gesamten Breite von $G_0$ angeordnet ist, um die Zeitspanne für die Verteilung der Ladungen unter $G_0$ zu reduzieren.

7. Generator nach einem der Ansprüche 1 bis 6, bei welchem die Spannung $V_x$ verfügbar ist und die Koeffizienten $a_0 \ldots a_n$ unbekannt sind, dadurch gekennzeichnet, daß er eine Injektionsdiode $D_e'$ umfaßt, die mit $D_e$ identisch ist, gefolgt von einem Elektrodenpaar aus einer Verschiebeelektrode $T_0'$ und einer Speicherelektrode $G_e'$, welches dem Paar $T_0 - G_e$ gleicht, wobei diese Diode $G_e'$ nacheinander auf hohen und auf niedrigen Pegel gelegt wird; wobei die Elektrode $T_0'$ auf $V_{GE}$ gelegt wird und die Elektrode $G_e'$ die Spannung $V_x$ empfängt, während die unter $G_e'$ injizierten Ladungen gelesen werden durch eine Vorrichtung, die identisch ist mit derjenigen, welche mit $G_2$ und $G_4$ verbunden ist, und wobei das Ergebnis dieses Auslesens verglichen wird mit dem unter $G_2$ und $G_4$ vorgenommenen Auslesevorgang, zur Bestimmung der Koeffizienten $a_0 \ldots a_n$.

8. Generator nach Anspruch 7, dadurch gekennzeichnet, daß die an $G_e'$ angelegte Spannung $V_x$ zwischen $V_0$ und $V_0 + V_{Ge}$ variiert und die unter $G_e'$ injizierte Ladungsmenge zwischen $Q_0$ und $Q_0 + 2Q_R$ variiert, wobei eine Ladungsgröße, die gleich $Q_0$ ist, den unter den Elektroden $G_2$ und $G_4$ ankommenden Ladungen hinzugefügt wird mittels einer Speicherelektrode $G_0''$, die an den Punkt P angeschlossen ist und unter welcher eine Ladungsgröße $Q_0$ durch eine Injektionsvorrichtung injiziert wird, die identisch mit derjenigen ist, welche die Ladungsgrößen $Q_0 + Q_x$ und $2Q_R$ erzeugt.

9. Generator nach Anspruch 7, dadurch gekennzeichnet, daß für eine negative Spannung $V_x$ vor der Durchführung des Vergleichs zwischen $V_x$ und den Spannungen $V_R$, $V_{Ri}$ die Spannungen $V_x$ oder die Spannungen $V_R$, $V_{Ri}$ durch eine Differentialstufe hinsichtlich ihres Vorzeichens invertiert werden.

10. Analog-Digital-Kodierer, dadurch gekennzeichnet, daß er einen Generator nach einem der Ansprüche 1 bis 9 enthält.

11. Analog-Digital-Dekoder, dadurch gekennzeichnet, daß er einen Generator nach einem der Ansprüche 1 bis 6 enthält.

## Claims

1. Charge transfer coded voltage generator generating the voltages

$$V_R, V_{Ri} = a_0 V_R + a_1 \cdot V_R/2 + a_2 \cdot V_R/2^2 + \ldots + a_{i-1} \cdot V_R/2^{i-1} + V_R/2^i,$$

wherein $V_R$ ist a reference voltage and where $i = 1 \ldots n$, these voltages allowing by comparison with a voltage $V_x$ to determine by successive approximations the coefficients $a_0 \ldots a_n$, equal to 0 or 1 and such

that

$$V_x = a_0 V_R + a_1 \cdot V_R/2 + a_2 \cdot V_R/2^2 \ldots + a_i V_R/2^i + \ldots + a_n \cdot V_R/2^n,$$

or generating the voltage

$$V_x = a_0 V_R + a_1 \cdot V_R/2 + a_2 \cdot V_R/2^2 + \ldots + a_i \cdot V_R/2^i + \ldots + a_n \cdot V_R/2^n$$

if the coefficients $a_0 \ldots a_n$ are known, characterized in that it is formed by a charge transfer device comprising alternating storage and transfer gates, including:

- at one end of the active zone where the transfer and the storage of the charges is performed, a diode $D_e$ assuring the injection of a reference charge quantity $2Q_R$ at the beginning of the processing of each sample $V_x$ or of each series $a_0 \ldots a_n$, and also assuring the removal of excessive charges in the course of the processing;
- an insulating diffusion separating the charges from one storage gate $G_0$ lying on the side of the diode $D_e$ into two equal parts, and which divides the active zone following $G_0$ into two parallel channels;
- on one channel a storage gate $G_2$ under which the charge quantities $Q_R, Q_R/2 \ldots Q_R/2^i \ldots$ are stored by successive forth and return movements between $G_0$ and $G_2$;
- three storage gates $G_1$, $G_3$ and $G_4$ on the other channel, the charge quantity $Q_R/2^i$ stored under $G_1$ from $G_0$ being transferred under $G_0$ and then evacuated under $D_e$ when $a_i$ equals 0, for $i = 0 \ldots n$, and being transferred under $G_3$ when $a_n$ equals 1;
- when the coefficients $a_0 \ldots a_n$ are unknown, a charge reading device connected to $G_2$ and $G_4$ and assuring the generation of $V_R$ during the transfer of $Q_R$ under $G_2$, allowing the determination of $a_0$ by comparison of $V_R$ with $V_x$, and then the generation of $V_{R1} = a_0 V_R + V_R/2$ during the transfer of $Q_R/2$ under $G_2$ and during the eventual transfer, when $a_0 = 1$, of $Q_R$ from $G_3$ to $G_4$, allowing the determination of $a_1$ by comparison of $V_{R1}$ with $V_x$, etc. until the generation of $V_{Rn}$ and the determination of $a_n$, or, when the coefficients $a_0 \ldots a_n$ are known, a charge reading device connected to $G_4$ and allowing the generation of $V_x$ by charge transfer from $G_3$ to $G_4$ when the n coefficients of $V_x$ have been processed.

2. Generator in accordance with claim 1, characterized in that the gates $G_1$ and $G_2$ have surfaces equal to half of that of the gates $G_0$, $G_3$ and $G_4$.

3. Generator in accordance with any of claims 1 and 2, characterized in that the two parallel channels have the same width.

4. Generator in accordance with any of claims 1 to 3, characterized in that the diode $D_e$ is followed by an electrode pair of a transfer electrode $T_0$ and a storage electrode $G_e$ receiving the same voltage ($V_{GE}$), the implantation beneath the transfer electrode $T_0$ being adapted to provide parallel surface potential curves in dependence on the voltage of this gate pair, and the diode $D_e$ being successively laid on a low level allowing the passage of the charges from $D_e$ beneath $T_0$ and $G_e$ and then on a high level allowing the storage of the charge quantity $2Q_R$ beneath $G_e$.

5. Generator in accordance with any of claims 1 to 4, characterized in that it comprises a diode ($D_c$) on one of the channels and following the storage gate $G_4$, said diode allowing the evacuation of the charges stored beneath $G_4$ at the end of the processing.

6. Generator in accordance with any of claims 1 to 5, characterized in that the storage gate $G_0$ having a width determined perpendicularly with respect to the charge transfer direction and sufficient to allow the charges stored beneath $G_0$ to be divided with good precision into two equal parts, a diffused zone of a type opposite to that of the substrate (1) being arranged across the entire width of $G_0$ for reducing the time for distribution of the charges beneath $G_0$.

7. Generator in accordance with any of claims 1 to 6, the voltage $V_x$ being available and the coefficients $a_0 \ldots a_n$ being unknown, characterized in that it comprises an injection diode $D_e'$ idential to $D_e$ followed by an electrode pair of a transfer electrode $T_0'$ and a storage electrode $G_e'$ identical to the pair $T_0 - G_e$, the diode $D_e'$ being successively laid on a low and on a high level; the gate $T_0'$ being brought to $V_{GE}$ and the gate $D_e'$ receiving the voltage $V_x$, the charges injected beneath $G_e'$ being read by a device identical to that which is connected to $G_2$ and $G_4$, and the result of this reading operation being compared with that performed beneath $G_2$ and $G_4$ for the determination of the coefficients $a_0 \ldots a_n$.

8. Generator in accordance with claim 7, characterized in that the voltage $V_x$ applied to $G_e'$ varies between $V_0$ and $V_0 + V_{Ge}$ and the charge quantity injected beneath $G_e'$ varies between $Q_0$ and $Q_0 + 2Q_R$, a charge quantity equal to $Q_0$ being added to the charges arriving beneath the gates $G_2$ and $G_4$ by means of a storage gate $G_0''$ connected to the point P, and beneath which a charge quantity $Q_0$ is injected by means of an injection device identical to that which generates the charge quantities $Q_0 + Q_x$ and $2Q_R$.

9. Generator in accordance with claim 7, characterized in that the voltage $V_x$ being negative, the

signs of the voltage $V_x$ or the voltages $V_R$, $V_{Ri}$ are inverted by a differential stage prior to performing the comparison between $V_x$ and the voltages $V_R$, $V_{Ri}$.

10. Analog-digital coder, characterized in that it comprises a generator in accordance with any of claims 1 to 9.

11. Analog-digital decoder, characterized in that it comprises a generator in accordance with any of claims 1 to 6.

FIG. 1

0 031 751

Fig. 2a

Fig. 2b

Fig. 3

Fig. 4